# EUROPEAN PATENT SPECIFICATION

(11) **EP 4 592 851 B1**
(45) Date of publication and mention of the grant of the patent: **28.10.2026**
(21) Application number: 24875660.3
(22) Date of filing: 09.01.2024
(51) Int. Cl.: G06F 11/36, G01R 31/36, G06F 11/3668, G01R 31/389, G01R 31/52

(54) **END-OF-LINE TESTING METHOD AND SYSTEM**
VERFAHREN UND SYSTEM ZUR LEITUNGSENDEPRÜFUNG
PROCÉDÉ ET SYSTÈME DE TEST DE FIN DE LIGNE

(30) Priority: 08.10.2023 CN 202311293184
(43) Date of publication of application: 30.07.2025
(73) Proprietor: Contemporary Amperex Technology (Hong Kong) Limited, Central (HK)
(72) Inventor: LI, Yanghu, Ningde, Fujian 352100 (CN); LIAN, Dengwei, Ningde, Fujian 352100 (CN); ZHAO, Tong, Ningde, Fujian 352100 (CN); CHEN, Chao, Ningde, Fujian 352100 (CN); WANG, Guangyi, Ningde, Fujian 352100 (CN); HAO, Pengfei, Ningde, Fujian 352100 (CN); ZHAO, Jiasheng, Ningde, Fujian 352100 (CN)
(74) Representative: Lorenz Seidler Gossel Part. mbB
(86) International application number: PCT/CN2024/071351
(87) International publication number: WO 2025/077043

(56) References cited:
- CN-A- 106 776 314
- CN-A- 115 114 147
- CN-A- 115 114 147
- CN-A- 115 343 626
- CN-A- 115 377 525
- CN-A- 117 031 285
- US-A1- 2014 068 410
- US-B1- 7 127 641

## Description

This disclosure is provided based on Chinese Patent Application No. 202311293184.0, filed on October 8, 2023 and entitled "END-OF-LINE TEST METHOD AND SYSTEM", and claims priority to this Chinese Patent Application.

### TECHNICAL FIELD

This disclosure relates to the field of battery technologies, and in particular, to an end-of-line test method and system.

### BACKGROUND

New energy batteries are increasingly widely used in life and industries. For example, new energy vehicles equipped with batteries have been widely used. In addition, batteries are increasingly used in the field of energy storage.

Currently, a test formula of a product is manually set on an upper-level computer to test the product, leading to low configuration efficiency. In addition, there may be a problem of incorrect configuration of the test formula. In other words, how to improve generation efficiency and accuracy of a test formula is an urgent problem to be resolved currently.

CN 115 114 147 A describes a test system in which a "configuration module" directly creates a test configuration in XML format based on a test instruction. This XML file is then used by a "test module" to control the test on the hardware. A similar is disclosed in CN 115 343 626 A. US 2014/068410 A1 discloses a graphical user interface ("Test Composer") that allows a user to edit test parameters in a table-like view. The Test Composer converts the user's inputs into an XML file, which is then used to run automated tests

### SUMMARY

Embodiments of this disclosure provide an end-of-line test method and system, which can effectively improve generation efficiency and accuracy of a test formula, thereby improving test efficiency.

The technical solutions of the embodiments of this disclosure are implemented as follows.

According to a first aspect, an embodiment of this disclosure provides an end-of-line test method applied to a test system according to the features of claim 1. The test system includes an upper-level computer, a test device, and a test requirement structured system, and the method includes:

The upper-level computer obtains an initial test formula from the test requirement structured system in response to a test formula download instruction, where the test requirement structured system is configured to generate the initial test formula based on a test item requirement, and the initial test formula includes related information of the test item requirement;
the upper-level computer converts the initial test formula into a target test formula in an extensible markup language format; and
the upper-level computer controls, based on the target test formula, the test device to test a product to obtain a test result.

In this embodiment, the test requirement structured system may generate the initial test formula based on the test item requirement. When receiving the test formula download instruction, the upper-level computer may directly obtain the initial test formula from the test requirement structured system, and then convert the initial test formula into the target test formula in the extensible markup language format, so that the target test formula for performing testing can be obtained without manual configuration on the upper-level computer. This can not only improve generation efficiency of a test formula but also improve accuracy of the test formula. In this way, the upper-level computer can directly test the product based on the target test formula, thereby effectively improving test efficiency.

According to the invention, a test item library and an instruction library are deployed on the upper-level computer, and that the upper-level computer converts the initial test formula into a target test formula in an extensible markup language format includes:
the upper-level computer performs matching processing on the initial test formula and the test item library to obtain test item data in an extensible markup language format,
the upper-level computer performs matching processing on the initial test formula and the instruction library to obtain an executable instruction in an extensible markup language format; and
the upper-level computer generates the target test formula based on the test item data in the extensible markup language format and the executable instruction in the extensible markup language format.

In this embodiment, when converting the initial test formula into the target test formula, the upper-level computer performs matching processing on the deployed test item library and instruction library and the initial test formula to obtain the test item data in the extensible markup language format and the executable instruction in the extensible markup language format, to form the target test formula. In this way, automatic conversion of the target test formula in the extensible markup language format is implemented. This improves the generation efficiency of the test formula.

In some embodiments of this disclosure, that the upper-level computer obtains an initial test formula from the test requirement structured system in response to a test formula download instruction includes:
the upper-level computer obtains, through querying, the initial test formula from test formula data stored in the test requirement structured system based on identification information indicated by the test formula download instruction, and downloads the initial test formula, where the identification information includes project identification information, production line identification information, and device identification information.

In this embodiment, the test requirement structured system may pre-store a plurality of pieces of test formula data. When obtaining the initial test formula from the test requirement structured system, the upper-level computer may query the test requirement structured system based on the identification information indicated by the test formula download instruction to determine the initial test formula corresponding to the identification information and download the initial test formula. In this way, the initial test formula is accurately obtained.

In some embodiments of this disclosure, the method further includes:
when receiving formula modify operation information, the upper-level computer modifies the target test formula to obtain a modified test formula, where the formula modify operation information includes test item add operation information, test item delete operation information, and execution sequence modify operation information, and
the upper-level computer controls, based on the modified test formula, the test device to test the product.

In this embodiment, when receiving the formula modify operation information, the upper-level computer may modify the target test formula. The formula modify operation information includes the test item add operation information, the test item delete operation information, and the execution sequence modify operation information, so that the upper-level computer can correspondingly perform a test item add operation, a test item delete operation, and a test item execution sequence modify operation to flexibly modify the target test formula, and after obtaining the modified test formula, the upper-level computer can directly perform testing based on the modified test formula. This further improves the test efficiency.

In some embodiments of this disclosure, the method further includes:
the upper-level computer sends the modified test formula to the test requirement structured system, so that the test requirement structured system stores the modified test formula.

In this embodiment, after obtaining the modified test formula, the upper-level computer may further send the modified test formula to the test requirement structured system for storage, so that when needing to obtain the modified test formula later, the upper-level computer can directly obtain the modified test formula from the test requirement structured system to perform testing without regenerating or being configured with the modified test formula. This improves obtaining efficiency of the test formula and test execution efficiency.

In some embodiments of this disclosure, the test system further includes a report system, and after that the upper-level computer controls, based on the target test formula, the test device to test a product to obtain a test result, the method further includes:
the upper-level computer generates a data report based on the test result and parameter code in the initial test formula, and sends the data report to the report system; and
the report system checks the data report.

In this embodiment, after obtaining the test result, the upper-level computer may further generate the data report based on the test result and the parameter code in the initial test formula, and send the data report to the report system, so that the report system can check the data report. This further improves test accuracy.

In some embodiments of this disclosure, the test requirement structured system may include a test item parameter configuration module and an operation step library module, and the method further includes:
the test requirement structured system obtains related configuration information of a parameter of a test item in response to operation information of the test item parameter configuration module;
the test requirement structured system obtains related configuration information of an operation step of the test item in response to operation information of the operation step library module; and
the test requirement structured system generates the initial test formula based on the related configuration information of the parameter and the related configuration information of the operation step.

In this embodiment, the test requirement structured system includes the test item parameter configuration module and the operation step library module. The test requirement structured system may obtain the related configuration information of the parameter of the test item in response to the operation information of the test item parameter configuration module, and the test requirement structured system may obtain the related configuration information of the operation step of the test item in response to the operation information of the operation step library module, so that the test requirement structured system can generate the initial test formula based on the related configuration information of the parameter and the related configuration information of the operation step. This effectively improves the generation efficiency of the initial test formula.

In some embodiments of this disclosure, the test item parameter configuration module includes a first configuration module and a second configuration module, and that the test requirement structured system obtains related configuration information of a parameter of a test item in response to operation information of the test item parameter configuration module includes:
the test requirement structured system obtains first parameter configuration information of the test item in response to first operation information corresponding to the first configuration module, where the first parameter configuration information includes at least a first parameter name, first parameter code, and a first parameter specification;
the test requirement structured system obtains second parameter configuration information of the test item in response to second operation information corresponding to the second configuration module, where the second parameter configuration information includes at least a second parameter name, second parameter code, and a second parameter specification; and
the test requirement structured system obtains the related configuration information of the parameter based on the first parameter configuration information and the second parameter configuration information.

In this embodiment, the test item parameter configuration module may include the first configuration module and the second configuration module. The test requirement structured system may obtain the first parameter configuration information of the test item in response to the first operation information corresponding to the first configuration module. The test requirement structured system may obtain the second parameter configuration information of the test item in response to the second operation information corresponding to the second configuration module. The first parameter configuration information may include at least the first parameter name, the first parameter code, and the first parameter specification, and the second parameter configuration information may include at least the second parameter name, the second parameter code, and the second parameter specification. In other words, the first configuration module and the second configuration module may be configured to provide related configuration information of different parameters of the test item, so that the test requirement structured system can obtain the related configuration information of the parameter based on the first parameter configuration information and the second parameter configuration information. This improves configuration efficiency of a test parameter.

In some embodiments of this disclosure, the method further includes:
the test requirement structured system sends the related configuration information of the parameter to the report system; and
the report system checks the data report based on the related configuration information of the parameter to determine whether the data report matches the related configuration information of the parameter.

In this embodiment, the test requirement structured system may further send the related configuration information of the parameter to the report system, so that the report system can check the data report based on the related configuration information of the parameter to determine whether the data report matches the related configuration information of the parameter. This further improves the test accuracy.

According to a second aspect, an embodiment of this disclosure provides a test system according to the features of claim 13.

In this embodiment, the upper-level computer in the test system is connected to the test device and the test requirement structured system, so that the upper-level computer can obtain the initial test formula from the test requirement structured system when receiving the test formula download instruction. The initial test formula is generated by the test requirement structured system, and the upper-level computer may automatically convert the initial test formula into the target test formula in the extensible markup language format. This improves obtaining efficiency of the test formula. In this way, the upper-level computer can control, based on the target test formula, the test device to test the product. This improves test efficiency.

In some embodiments of this disclosure, the test system further includes a report system, and the report system is connected to the upper-level computer and the test requirement structured system; and
the report system is configured to: receive related configuration information of a parameter sent by the test requirement structured system and a data report sent by the upper-level computer, and check the data report based on the related configuration information of the parameter to determine whether the data report matches the related configuration information of the parameter.

In these embodiment, the report system is connected to the upper-level computer and the test requirement structured system, so that the report system can receive the data report sent by the upper-level computer and the related configuration information of the parameter sent by the test requirement structured system. In this way, the report system can check the data report based on the related configuration information of the parameter to determine whether the data report matches the related configuration information of the parameter. This can further improve test accuracy and reliability.

### BRIEF DESCRIPTION OF DRAWINGS

FIG. 1 is a first schematic diagram of a composition structure of a test system according to an embodiment of this disclosure;
FIG. 2 is a first schematic diagram of an implementation procedure of an end-of-line test method according to an embodiment of this disclosure;
FIG. 3 is a schematic implementation diagram of downloading an initial test formula according to an embodiment of this disclosure;
FIG. 4 is a first schematic diagram of a display interface of an upper-level computer according to an embodiment of this disclosure;
FIG. 5 is a second schematic diagram of a display interface of an upper-level computer according to an embodiment of this disclosure;
FIG. 6 is a schematic diagram of a composition structure of a test requirement structured system according to an embodiment of this disclosure;
FIG. 7 is a second schematic diagram of an implementation procedure of an end-of-line test method according to an embodiment of this disclosure;
FIG. 8 is a schematic diagram of a composition structure of a test item parameter configuration module according to an embodiment of this disclosure;
FIG. 9 is a schematic diagram of a generation manner of an initial test formula according to an embodiment of this disclosure,
FIG. 10 is a schematic implementation diagram of an end-of-line test method according to an embodiment of this disclosure; and
FIG. 11 is a second schematic diagram of a composition structure of a test system according to an embodiment of this disclosure.

### DESCRIPTION OF EMBODIMENTS

The following clearly and completely describes the technical solutions in embodiments of this disclosure with reference to the accompanying drawings in the embodiments of this disclosure. It can be understood that the specific embodiments described herein are merely used to explain this application, but are not intended to limit this application. In addition, it should be noted that, for ease of description, only a part related to this application is shown in the accompanying drawings.

Currently, new energy batteries are increasingly widely used in life and industries. The new energy batteries are used in energy storage power supply systems such as hydroelectric power plants, thermal power plants, wind power plants, and solar power plants, and in many other fields including electric transportation tools such as electric bicycles, electric motorcycles, and electric vehicles, and aerospace. With the continuous expansion of application fields of power batteries, market demands for the power batteries are also increasing.

In the embodiments of this disclosure, a battery may be a battery cell (sometimes also referred to as a cell), and the battery may alternatively be a battery module or battery pack including a plurality of battery cells. A battery cell is a basic unit that can implement mutual conversion between chemical energy and electric energy, and can be configured to manufacture a battery module or a battery pack, to supply power to an electric apparatus. The battery cell may be a secondary battery, and the secondary battery is a battery cell whose active material can be activated for reuse through charging after the battery cell is discharged. The battery cell may be a lithium-ion battery, a sodium-ion battery, a sodium-lithium-ion battery, a lithium metal battery, a sodium metal battery, a lithium-sulfur battery, a magnesium-ion battery, a nickel-hydrogen battery, a nickel-cadmium battery, a lead storage battery, or the like. This is not limited in the embodiments of this disclosure.

To resolve a problem existing in the existing test method, the embodiments of this disclosure provide an end-of-line test method and system. The test system may include an upper-level computer, a test device, and a test requirement structured system. The upper-level computer may obtain an initial test formula from the test requirement structured system in response to a test formula download instruction, where the test requirement structured system is configured to generate the initial test formula based on a test item requirement, and the initial test formula includes related information of the test item requirement; convert the initial test formula into a target test formula in an extensible markup language format; and control, based on the target test formula, the test device to test a product to obtain a test result. This can effectively improve generation efficiency and accuracy of the test formula, thereby improving test efficiency.

The following clearly and completely describes the technical solutions in the embodiments of this disclosure with reference to the accompanying drawings in the embodiments of this disclosure.

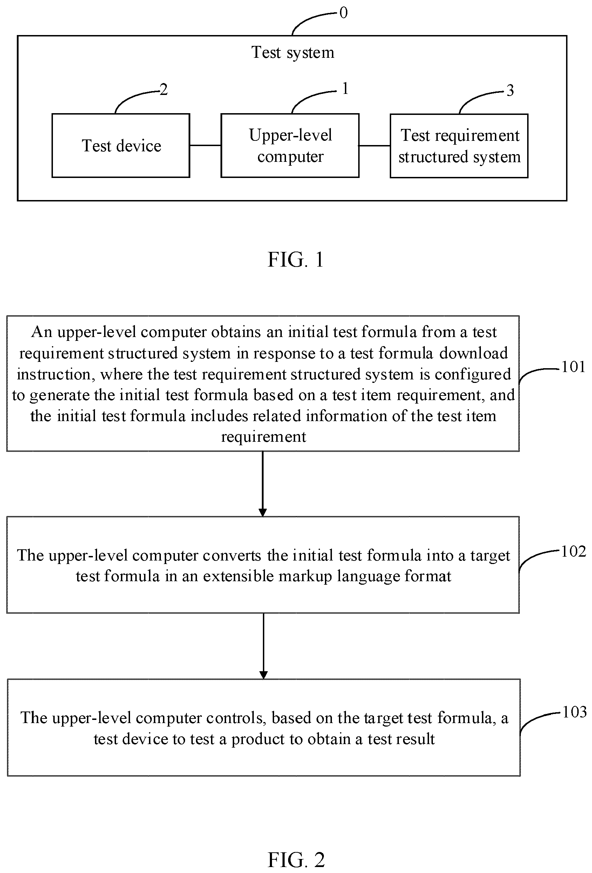

An embodiment of this disclosure provides an end-of-line (End of Line, EOL) test method, applied to a test system. As shown in FIG. 1, the test system 0 may include an upper-level computer 1, a test device 2, and a test requirement structured system 3. The test device 2 may be connected to the upper-level computer 1, and the test requirement structured system 3 may be connected to the upper-level computer 1.

The upper-level computer 1 may be configured to: obtain an initial test formula from the test requirement structured system in response to a test formula download instruction, convert the initial test formula into a target test formula in an extensible markup language format, and control, based on the target test formula, the test device to test a product to obtain a test result. The test requirement structured system 3 may be configured to generate the initial test formula based on a test item requirement. The test device 2 may be configured to test the product.

FIG. 2 is a schematic diagram 1 of an implementation procedure of an end-of-line test method according to an embodiment of this disclosure. As shown in FIG. 2, the end-of-line test method may include the following steps.

Step 101: An upper-level computer obtains an initial test formula from a test requirement structured system in response to a test formula download instruction, where the test requirement structured system is configured to generate the initial test formula based on a test item requirement, and the initial test formula includes related information of the test item requirement.

In this embodiment of this disclosure, the upper-level computer in the test system may obtain the initial test formula from the test requirement structured system in response to the test formula download instruction. The test requirement structured system is configured to generate the initial test formula based on the test item requirement, and the initial test formula includes the related information of the test item requirement.

It should be noted that in this embodiment of this disclosure, the upper-level computer may receive the test formula download instruction, and then the upper-level computer may obtain the initial test formula from the test requirement structured system in response to the test formula download instruction.

In this embodiment of this disclosure, the test device may be a device for testing a product, and the upper-level computer may control the test device to test the product.

For example, a display interface of the upper-level computer displays a "download" icon. When the upper-level computer receives "download" icon trigger operation information of a user on the display interface, it may be considered that the upper-level computer receives the test formula download instruction, so that the upper-level computer can obtain the initial test formula from the test requirement structured system.

It should be noted that in this embodiment of this disclosure, the test requirement structured system may include a configuration module for editing the test item requirement. The test requirement structured system may configure the test item requirement in response to operation information corresponding to the configuration module to generate the initial test formula including the related information of the test item requirement.

In some embodiments of this disclosure, the test requirement structured system may be deployed on a server, and after obtaining the initial test formula, the test requirement structured system may store the initial test formula, for example, in the server.

In some embodiments of this disclosure, when obtaining the initial test formula from the test requirement structured system in response to the test formula download instruction, the upper-level computer may obtain, through querying, the initial test formula from test formula data stored in the test requirement structured system based on identification information indicated by the test formula download instruction, and download the initial test formula. The identification information includes project identification information, production line identification information, and device identification information.

In some embodiments of this disclosure, the project identification information may be a product number (Product Number, PN) of a project, the production line identification information may be a number of a production line of a battery, and the device identification information may be a number of a work center corresponding to the test requirement structured system and a report system.

In these embodiments of this disclosure, each initial test formula may have corresponding identification information in the test formula data stored in the test requirement structured system, so that when querying the test formula data, the upper-level computer can query the test formula data based on the identification information indicated by the test formula download instruction, determine an initial test formula corresponding to identification information the same as the identification information indicated by the test formula download instruction, and download the initial test formula.

In some embodiments of this disclosure, the upper-level computer may download the initial test formula from the test requirement structured system through the file transfer protocol (File Transfer Protocol, FTP).

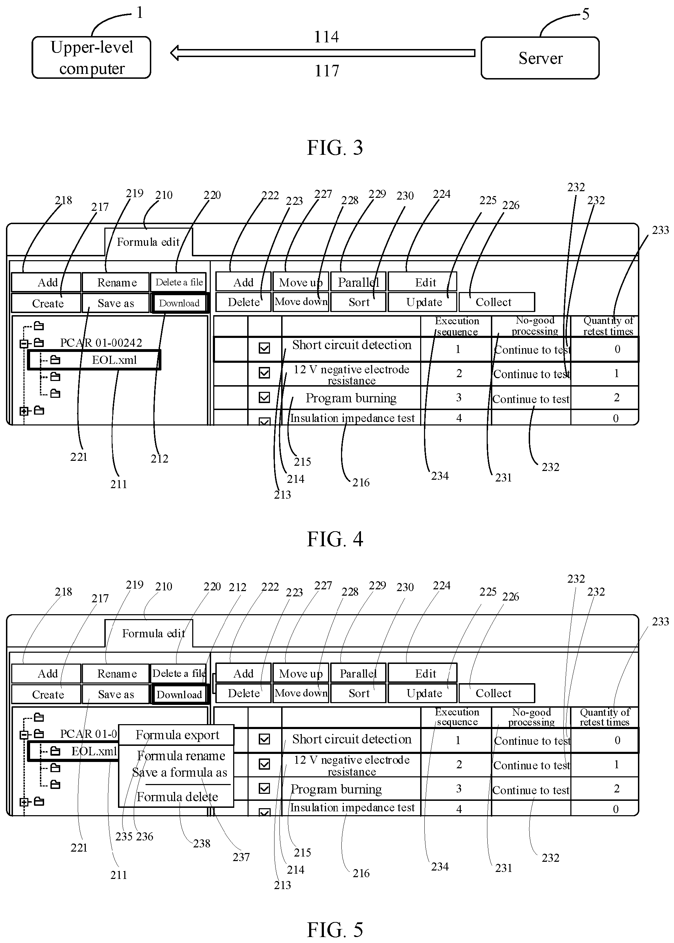

For example, as shown in FIG. 3, the upper-level computer 1 may download, through the FTP, the initial test formula from the server 5 in which the test requirement structured system 3 is located. The test requirement structured system may store the initial test formula in the server 5 after obtaining the initial test formula, so that when downloading the initial test formula, the upper-level computer 1 can download the initial test formula 114 from the server 5 in which the test requirement structured system 3 is located. For example, the upper-level computer may query the test formula data in the server 5 based on the identification information 117 including the project identification information, the production line identification information, and the device identification information, obtain the initial test formula matching the project identification information, the production line identification information, and the device identification information, and download the initial test formula.

Step 102: The upper-level computer converts the initial test formula into a target test formula in an extensible markup language format.

In these embodiments of this disclosure, the upper-level computer may convert the initial test formula into the target test formula in the extensible markup language format after obtaining the initial test formula from the test requirement structured system in response to the test formula download instruction.

It should be noted that in these embodiments of this disclosure, the target test formula is a test formula in an extensible markup language (Extensible Markup Language, XML) format.

In some embodiments of this disclosure, a test item library and an instruction library may be deployed on the upper-level computer.

In some embodiments of this disclosure, when converting the initial test formula into the target test formula in the extensible markup language format, the upper-level computer may perform matching processing on the initial test formula and the test item library to obtain test item data in an extensible markup language format, perform matching processing on the initial test formula and the instruction library to obtain an executable instruction in an extensible markup language format, and generate the target test formula based on the test item data in the extensible markup language format and the executable instruction in the extensible markup language format.

In these embodiments of this disclosure, the upper-level computer may include a file conversion module, and the upper-level computer may convert the initial test formula into the target test formula in the extensible markup language format by using the file conversion module.

It can be understood that in these embodiments of this disclosure, the upper-level computer may interact with the test requirement structured system, and perform automatic matching and loading on the test item library and the instruction library by using the file conversion module, to generate the target test formula with the executable instruction.

For example, as shown in FIG. 4, in a formula edit 210 operation page in the display interface of the upper-level computer, the upper-level computer may receive a folder creation operation triggered by the user and create a folder for end-of-line testing. The folder is named in the same way as the project identification information, and a name format of the folder may be PCAR xxxx. For example, if the project identification information is 01-00242, the created folder is named PCAR 01-00242 as shown in FIG. 4, and a blank formula under the folder is EOL.xml 211. Then, after receiving a download operation triggered by clicking a download button 212 by the user, the upper-level computer obtains the initial test formula from the test requirement structured system in response to the test formula download instruction, converts the initial test formula into the target test formula in the extensible markup language format, and displays a test item in the target test formula in the display interface. For example, the obtained target test formula includes four test items as shown in FIG. 4: short circuit detection 213, 12 V negative electrode resistance 214, program burning 215, and an insulation impedance test 216. In addition, it can be learned from FIG. 4 that in addition to supporting creation 217 of the folder, the upper-level computer may further support other operations on the folder, such as operations of adding 218, renaming 219, and deleting a file 220, and saving the file as 221, operations of adding 222, deleting 223, editing 224, updating 225, and collecting 226 test items, and operations of moving up 227 and moving down 228 an execution sequence 234 of a test item, paralleling 229 test items, and sorting 230 test items. In addition, the formula edit 210 operation page may further include no-good (NG) processing 231 on a test item. For example, the no-good processing may include an operation of continuing to perform testing 232 and a quantity of retest times 233. For example, for short circuit detection 213, the quantity of retest times is 0, and for 12 V negative electrode resistance 214, the quantity of retest times is 1.

In some embodiments of this disclosure, when receiving formula modify operation information, the upper-level computer may further modify the target test formula to obtain a modified test formula, where the formula modify operation information includes test item add operation information, test item delete operation information, and execution sequence modify operation information; and control, based on the modified test formula, the test device to test the product.

It can be understood that in these embodiments of this disclosure, the test item add operation information may be used to continue to add a test item in the target test formula, the test item delete operation information may be used to delete a test item from the target test formula, and the execution sequence modify operation information may be used to modify an execution sequence of a test item in the target test formula.

For example, as shown in FIG. 4, when receiving operation information of adding 218 (the test item add operation information), in the display interface, triggered by the user, the upper-level computer may continue to add a test item to a test item in the current target test formula. When receiving operation information of deleting 223 (the test item delete operation information), in the display interface, triggered by the user, the upper-level computer may delete a test item from the current target test formula. When receiving icon operation information of moving up 227, moving down 228, and sorting 230 (the execution sequence modify operation information), in the display interface, triggered by the user, the upper-level computer may modify an execution sequence of a test item in the current target test formula, such as the four test items in FIG. 3. Before the execution sequence is modified, short circuit detection is first performed, then 12 V negative electrode resistance is performed, then program burning is performed, and finally, the insulation impedance test is performed. An execution sequence of 12 V negative electrode resistance may be "moved up", so that 12 V negative electrode resistance is first performed, and then short circuit detection is performed. Alternatively, program burning is "moved down", so that program burning is last performed.

In some embodiments of this disclosure, after obtaining the modified test formula, the upper-level computer may further send the modified test formula to the test requirement structured system, so that the test requirement structured system stores the modified test formula.

For example, the upper-level computer may send the modified test formula to the test requirement structured system, and the test requirement structured system stores the modified test formula in the server in which the test requirement structured system is located.

In some embodiments of this disclosure, when the modified test formula needs to be used for product testing again, the upper-level computer may directly obtain the modified test formula from the test requirement structured system and perform testing without regenerating or being configured with the modified test formula. This facilitates subsequent retrieval and use, and can improve obtaining efficiency of the test formula and test execution efficiency.

In some embodiments of this disclosure, as shown in FIG. 5, the upper-level computer may further locally export the target test formula or the modified test formula in response to an operation of formula export 235, to perform testing. In addition, as shown in FIG. 5, in addition to in response to the operation of formula export 235, the upper-level computer may further support an operation of formula rename 236, an operation of saving a formula as 237, and an operation of formula delete 238.

Step 103: The upper-level computer controls, based on the target test formula, the test device to test a product to obtain a test result.

In these embodiments of this disclosure, after converting the initial test formula into the target test formula in the extensible markup language format, the upper-level computer may control, based on the target test formula, the test device to test the product to obtain the test result.

In these embodiments of this disclosure, the product may be a target under end-of-line test. For example, the product may be a battery, and an insulation resistance test, a withstand voltage test, or the like is performed on the battery.

In some embodiments of this disclosure, after controlling, based on the target test formula, the test device to test the product to obtain the test result, the upper-level computer may further generate a data report based on the test result and parameter code in the initial test formula, and send the data report to the report system, so that the report system can check the data report.

It should be noted that in these embodiments of this disclosure, the report system may be a report system corresponding to a manufacturing execution system (Manufacturing Execution System, MES). The report system may be deployed on the server, and the report system may check the data report based on related configuration information of a parameter sent by the test requirement structured system to determine whether the data report is a data report corresponding to the product indicated by the related configuration information of the parameter.

In some embodiments of this disclosure, when the test item is the insulation impedance test, and the upper-level computer controls, based on the target test formula, the test device to test the product to obtain a test result, the upper-level computer may control, based on the target test formula, the test device to perform the insulation impedance test on the product to obtain a test result of the insulation impedance test. The test result of the insulation impedance test includes a parameter test result for testing a parameter of the insulation impedance test. The parameter of the insulation impedance test includes at least one of an insulation test voltage, an insulation limiting voltage, an insulation rising time, an insulation falling time, a positive insulation impedance to ground, and a negative insulation impedance to ground.

In some embodiments of this disclosure, when the test item is the short circuit detection, and the upper-level computer controls, based on the target test formula, the test device to test the product to obtain a test result, the upper-level computer may control, based on the target test formula, the test device to perform the short circuit detection on the product to obtain a test result of the short circuit detection. The test result of the short circuit detection includes a parameter test result for testing a parameter of the short circuit detection. The parameter of the short circuit detection includes at least one of a positive resistance to ground, a negative resistance to ground, and a positive-negative resistance.

In some embodiments of this disclosure, when the test item is the 12 V negative electrode resistance, and the upper-level computer controls, based on the target test formula, the test device to test the product to obtain a test result, the upper-level computer may control, based on the target test formula, the test device to perform the 12 V negative electrode resistance test on the product to obtain a test result of the 12 V negative electrode resistance test. The test result of the 12 V negative electrode resistance test includes a parameter test result for testing a parameter of the 12 V negative electrode resistance test. The parameter of the 12 V negative electrode resistance test may include a conducting resistance.

In some embodiments of this disclosure, when the test item is the program burning, and the upper-level computer controls, based on the target test formula, the test device to test the product to obtain a test result, the upper-level computer may control, based on the target test formula, the test device to perform the program burning test on the product to obtain a test result of the program burning test. The test result of the program burning test includes a parameter test result for testing a parameter of the program burning test. The parameter of the program burning test includes at least one of boot (Boot) version information, battery management unit (Battery Management Unit, BMU) software (software) version information, and battery management unit hardware (hardware) version information.

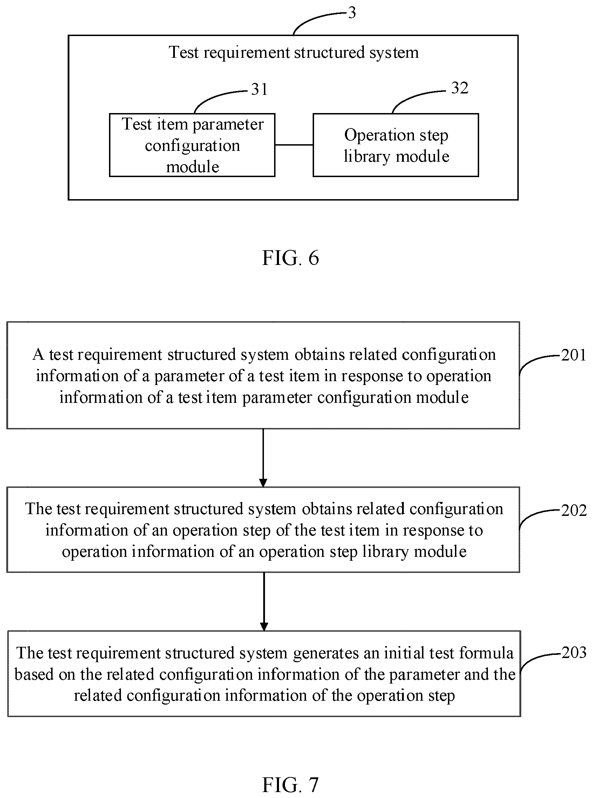

FIG. 6 is a schematic diagram 1 of a composition structure of the test requirement structured system according to an embodiment of this disclosure. As shown in FIG. 6, the test requirement structured system 3 may include a test item parameter configuration module 31 and an operation step library module 32. Based on FIG. 6, this embodiment of this disclosure provides an end-of-line test method. As shown in FIG. 7, the end-of-line test method may further include the following steps.

Step 201: The test requirement structured system obtains related configuration information of a parameter of a test item in response to operation information of the test item parameter configuration module.

In this embodiment of this disclosure, the test requirement structured system may obtain the related configuration information of the parameter of the test item in response to the operation information of the test item parameter configuration module.

In this embodiment of this disclosure, the test item parameter configuration module may be configured to configure the parameter of the test item. The related configuration information of the parameter may at least include a parameter name, parameter code, and parameter specification information.

For example, the test item is an insulation impedance test. The test item includes a parameter named an insulation test voltage. The insulation test voltage may be used as a parameter name, parameter code of the insulation test voltage is ABCDE, and parameter specification information may include related information of a product specification or a process specification corresponding to the insulation test voltage.

For example, the test item is short circuit detection. The test item includes three parameters named a positive resistance to ground, a negative resistance to ground, and a positive-negative resistance. The positive resistance to ground, the negative resistance to ground, and the positive-negative resistance may be used as parameter names.

For example, the test item is 12 V negative electrode resistance. The test item includes a parameter named a conducting resistance. The conducting resistance may be used as a parameter name.

For example, the test item is program burning. The test item includes three parameters named boot version information, battery management unit software version information, and battery management unit hardware version information. The boot version information, the battery management unit software version information, and the battery management unit hardware version information may be used as parameter names.

In some embodiments of this disclosure, in addition to the parameter name, the parameter code, and the parameter specification information, the related configuration information of the parameter may further include information such as test item execution process information, a number of a test item, a data storage manner, and a production device. For example, when the test item is the insulation impedance test, the test item execution process information may be description information of an execution process or execution step of the insulation impedance test, a number of the test item is a number of the insulation impedance test, for example, 12345, and the production device is, for example, a dielectric withstand tester.

In these embodiments of this disclosure, the operation information of the test item parameter configuration module may be operation information of obtaining the related configuration information of the parameter by using the test item parameter configuration module. When receiving the operation information of the test item parameter configuration module, in response to the operation information of the test item parameter configuration module, the test requirement structured system may obtain the related configuration information of the parameter of the test item corresponding to the operation information of the test item parameter configuration module.

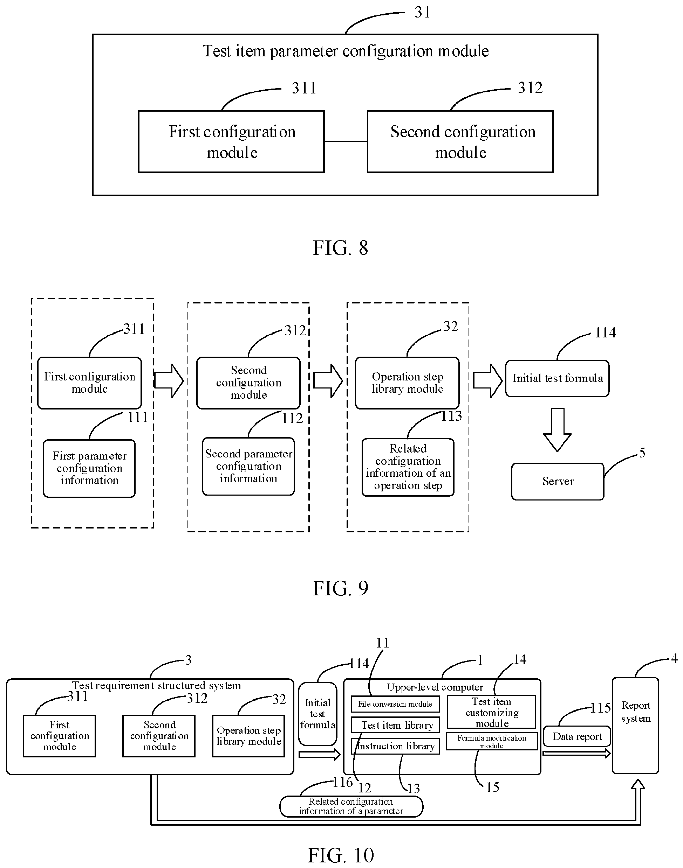

In some embodiments of this disclosure, as shown in FIG. 8, the test item parameter configuration module 31 may include a first configuration module 311 and a second configuration module 312.

It should be noted that in these embodiments of this disclosure, the first configuration module may be an end test requirement (End Test Requirement, ETR) module, and the first configuration module may be configured to provide related information of a test item and parameter specification.

It should be noted that in these embodiments of this disclosure, the second configuration module may be an end control plan (End Control Plan, ECP) module, and the second configuration module may be configured to provide related information of a test item, product specification, and process specification.

In some embodiments of this disclosure, when obtaining the related configuration information of the parameter of the test item in response to the operation information of the test item parameter configuration module, the test requirement structured system may obtain first parameter configuration information of the test item in response to first operation information corresponding to the first configuration module, where the first parameter configuration information includes at least a first parameter name, first parameter code, and a first parameter specification; the test requirement structured system obtains second parameter configuration information of the test item in response to second operation information corresponding to the second configuration module, where the second parameter configuration information includes at least a second parameter name, second parameter code, and a second parameter specification; and the test requirement structured system obtains the related configuration information of the parameter based on the first parameter configuration information and the second parameter configuration information.

It should be noted that in these embodiments of this disclosure, the first operation information may be operation information of obtaining the first parameter configuration information of the test item by using the first configuration module. When receiving the first operation information, in response to the first operation information, the test requirement structured system may obtain the first parameter configuration information of the test item corresponding to the first operation information.

In these embodiments of this disclosure, the second operation information may be operation information of obtaining the second parameter configuration information of the test item by using the second configuration module. When receiving the second operation information, in response to the second operation information, the test requirement structured system may obtain the second parameter configuration information of the test item corresponding to the second operation information.

It can be understood that in these embodiments of this disclosure, the first configuration module and the second configuration module may be configured to provide related configuration information of different parameters, that is, the first parameter configuration information is different from the second parameter configuration information.

For example, the test item is the insulation impedance test. The first parameter configuration information obtained by using the first configuration module may include at least an insulation test voltage (the first parameter name), ABCDE (the first parameter code), and related information of a product specification or process specification corresponding to the insulation test voltage (the first parameter specification). The second parameter configuration information obtained by using the second configuration module may include at least an insulation limiting voltage (the second parameter name), FGHIJ (the second parameter code), and related information of a product specification or process specification corresponding to the insulation limiting voltage (the second parameter specification).

For example, the first parameter configuration information obtained by using the first configuration module is shown in the following Table 1.

**Table 1**

| Test item | Test station | Parameter code | Parameter name | Parameter specification information | | | | |
|---|---|---|---|---|---|---|---|---|
| | | | | Product/Process specification | Lower limit value | Parameter value | Upper limit value | Parameter unit |
| | | xxx | Insulation test voltage | Process specification | | xx | | V |
| | | xxx | Insulation rising time | Process specification | | xx | | s |
| Insulation impedance test | End-of-line test station | xxx | Insulation test time | Process specification | | xx | | s |
| | | xxx | Insulation falling time | Process specification | | xx | | s |
| | | xxx | Positive insulation impedance to ground | Product specification | 10 | | | MΩ |
| | | xxx | Negative insulation impedance to ground | Product specification | 10 | | | MΩ |

For example, the related configuration information of the parameter obtained based on the first parameter configuration information and the second parameter configuration information is shown in the following Table 2.

**Table 2**

| Test item | Test station | Parameter code | Parameter name | Parameter specification information | | | | | |
|---|---|---|---|---|---|---|---|---|---|
| | | | | Parameter source | Product/Process specification | Lower limit value | Parameter value | Upper limit value | Parameter unit |
| | | xxxx | Insulation test voltage | First configuration module | Process specification | | xx | | V |
| | | xxxx | Insulation limiting voltage | Second configuration module | Process specification | | xx | | V |
| | | xxxx | Lower limit of an insulation resistance of a dielectric withstand tester | Second configuration module | Process specification | | xx | | |
| Insulation impedance test | End-of-line test station | xxxx | Insulation rising time | First configuration module | Process specification | | xx | | s |
| | | xxxx | Insulation test time | First configuration module | Process specification | | xx | | s |
| | | xxxx | Insulation falling time | First configuration module | Process specification | | xx | | s |
| | | xxxx | Positive insulation impedance to ground | First configuration module | Product specification | 10 | | | MΩ |
| | | xxxx | Negative insulation impedance to ground | First configuration module | Product specification | 10 | | | MΩ |

In some embodiments of this disclosure, the test requirement structured system may further send the related configuration information of the parameter to the report system, and the report system checks the data report based on the related configuration information of the parameter to determine whether the data report matches the related configuration information of the parameter.

The data report is generated by the upper-level computer based on the test result and the parameter code. After generating the data report, the upper-level computer may send the data report to the report system.

In some embodiments of this disclosure, when sending the related configuration information of the parameter to the report system, the test requirement structured system may send the parameter code and the parameter specification information in the related configuration information of the parameter to the report system, and the report system may check the data report based on the parameter code and the parameter specification information.

Step 202: The test requirement structured system obtains related configuration information of an operation step of the test item in response to operation information of the operation step library module.

In these embodiments of this disclosure, after obtaining the related configuration information of the parameter of the test item in response to the operation information of the test item parameter configuration module, the test requirement structured system may obtain the related configuration information of the operation step of the test item in response to the operation information of the operation step library module.

It should be noted that in these embodiments of this disclosure, the operation step library module may be configured to provide related information of a standard operation step.

It should be noted that in these embodiments of this disclosure, the operation information of the operation step library module may be operation information of obtaining operation step information of the test item by using the operation step library module. When receiving the operation information of the operation step library module, in response to the operation information of the operation step library module, the test requirement structured system may obtain the operation step information of the test item corresponding to the operation information of the operation step library module.

In some embodiments of this disclosure, the related configuration information of the operation step may include an operation step sequence, operation step code, an operation step name, an operation step type, delay information, and the like. The delay information may include pre-delay and post-delay.

For example, the test item is the insulation impedance test. The related configuration information of the operation step is shown in the following Table 3.

**Table 3**

| Operation step sequence | Operation step code | Operation step name | Operation step type | Pre-delay (ms) | Post-delay (ms) |
|---|---|---|---|---|---|
| 1 | xxxx | Preparation of an insulation impedance test | Other (other) | 0 | 20 |
| 2 | | Insulation impedance test positive to ground | Judge (Judge) | 0 | 20 |
| 3 | | Insulation impedance test negative to ground | Judge (Judge) | 0 | 20 |

Step 203: The test requirement structured system generates the initial test formula based on the related configuration information of the parameter and the related configuration information of the operation step.

In these embodiments of this disclosure, after obtaining the related configuration information of the operation step of the test item in response to the operation information of the operation step library module, the test requirement structured system generates the initial test formula based on the related configuration information of the parameter and the related configuration information of the operation step. For example, as shown in FIG. 9, when generating the initial test formula, the test requirement structured system may first obtain the first parameter configuration information 111 of the test item by using the first configuration module 311. For example, the first parameter configuration information includes a name of the test item and related configuration information of some parameters. Then, the test requirement structured system may obtain the second parameter configuration information 112 by using the second configuration module 312 and the related configuration information of the operation step 113 by using the operation step library module 32. For example, the operation step information of the test item may include an operation step name of the test item, an operation step sequence of the test item, and no-good (NG) processing of the test item. Further, after obtaining the initial test formula 114 based on the first parameter configuration information 111, the second parameter configuration information 112, and the related configuration information of the operation step 113, the test requirement structured system may store the obtained initial test formula 114 in the server 5.

Based on the embodiment shown in FIG. 9, when the test system performs an end-of-line test, as shown in FIG. 10, the upper-level computer 1 in the test system may obtain the initial test formula 114 from the test requirement structured system 3, and then the upper-level computer 1 may convert the initial test formula into the target test formula in the extensible markup language format by using the file conversion module 11. The upper-level computer performs automatic matching and loading on the test item library 12 and the instruction library 13 by using the file conversion module, to generate the target test formula with an executable instruction. In addition, the upper-level computer further supports formula modification. For example, the upper-level computer may include a test item customizing module 14 to support an operation of customizing a test item and a formula modification module 15 configured to modify and maintain the target test formula. After controlling the test device to perform testing, the upper-level computer may further generate the data report 115 based on the test result and the parameter code, and send the data report 115 to the report system 4. In addition, the test requirement structured system 3 may also send the related configuration information of the parameter 116, such as the parameter code and the parameter specification information in the related configuration information of the parameter to the report system 4, so that the report system 4 can check the data report based on the parameter code in the related configuration information of the parameter to determine whether the parameter code in the data report is consistent with the parameter code in the related configuration information of the parameter. This improves accuracy of the data report.

In these embodiments of this disclosure, software for automatically obtaining the initial test formula and the file conversion module may be developed based on C#, so that the initial test formula on the server can be automatically extracted and matched and reformulated based on the integrated test item library and instruction library on the upper-level computer to generate the formal target test formula. The test requirement structured system may automatically transmit the parameter code and the parameter specification information to the report system to automatically generate a product test data collection group, and the report system may check and perform error prevention on the data report corresponding to the test result. This further improves the test accuracy.

In conclusion, in these embodiments of this disclosure, a product test requirement may be divided into a plurality of structured modules by using the test requirement structured system, such as the first configuration module, the second configuration module, and the operation step library module, the modules can be combined and configured to generate the initial test formula, the initial test formula is stored in the server, and then the upper-level computer in the test device interacts with the test requirement structured system to automatically convert the initial test formula into the target test formula in the extensible markup language format. In addition, the report system can receive the data report and automatically collect test data. Based on the foregoing manner, the test system can automatically transmit the test data. This reduces an error rate of manual formula editing and improves accuracy of the test formula, thereby improving detection quality.

In these embodiments of this disclosure, the test system may include an upper-level computer, a test device, and a test requirement structured system. The upper-level computer may obtain an initial test formula from the test requirement structured system in response to a test formula download instruction, where the test requirement structured system is configured to generate the initial test formula based on a test item requirement, and the initial test formula includes related information of the test item requirement. The upper-level computer converts the initial test formula into a target test formula in an extensible markup language format. The upper-level computer controls, based on the target test formula, the test device to test a product to obtain a test result. It can be seen that the test requirement structured system may generate the initial test formula based on the test item requirement. When receiving the test formula download instruction, the upper-level computer may directly obtain the initial test formula from the test requirement structured system, and then convert the initial test formula into the target test formula in the extensible markup language format, so that the target test formula for performing testing can be obtained without manual configuration on the upper-level computer. This can improve generation efficiency of a test formula and accuracy of the test formula. In this way, the upper-level computer can directly test the product based on the target test formula. This can effectively improve test efficiency.

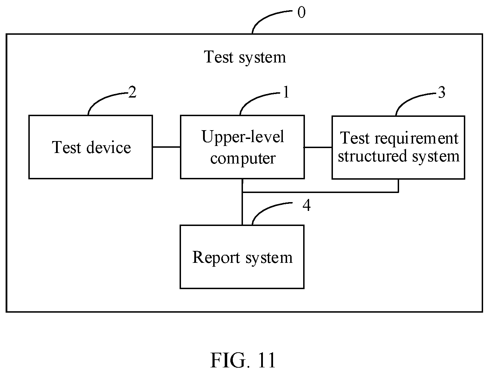

Based on the foregoing embodiments, another embodiment of this disclosure provides a test system. As shown in FIG. 11, the test system 0 may include an upper-level computer 1, a test device 2, a test requirement structured system 3, and a report system 4. The test device 2 may be connected to the upper-level computer 1, the test requirement structured system 3 may be connected to the upper-level computer 1, and the report system 4 may be connected to the upper-level computer 1 and the test requirement structured system 3.

The test requirement structured system 3 may be configured to generate an initial test formula based on a test item requirement, where the initial test formula includes related information of the test item requirement.

The upper-level computer 1 may be configured to: obtain the initial test formula from the test requirement structured system in response to a test formula download instruction, convert the initial test formula into a target test formula in an extensible markup language format, and control, based on the target test formula, the test device to test a product to obtain a test result.

In some embodiments, the upper-level computer 1 may be further configured to perform matching processing on the initial test formula and a test item library to obtain test item data in an extensible markup language format, perform matching processing on the initial test formula and an instruction library to obtain an executable instruction in an extensible markup language format, and generate the target test formula based on the test item data in the extensible markup language format and the executable instruction in the extensible markup language format.

In some embodiments, the upper-level computer 1 may be further configured to: obtain, through querying, the initial test formula from test formula data stored in the test requirement structured system 3 based on identification information indicated by the test formula download instruction, and download the initial test formula, where the identification information includes project identification information, production line identification information, and device identification information.

In some embodiments, when receiving formula modify operation information, the upper-level computer 1 may be further configured to modify the target test formula to obtain a modified test formula, where the formula modify operation information includes test item add operation information, test item delete operation information, and execution sequence modify operation information, and the upper-level computer controls, based on the modified test formula, the test device to test the product.

In some embodiments, the upper-level computer 1 may be further configured to send the modified test formula to the test requirement structured system 3, so that the test requirement structured system 3 can store the modified test formula.

In some embodiments, the upper-level computer 1 may be further configured to generate a data report based on the test result and parameter code in the initial test formula, and send the data report to the report system 4.

In some embodiments, the test requirement structured system 3 may include a test item parameter configuration module 31 and an operation step library module 32.

The test item parameter configuration module 31 may be configured to obtain related configuration information of a parameter of a test item based on corresponding operation information.

The test item parameter configuration module 31 may include a first configuration module 311 and a second configuration module 312.

The first configuration module 311 may be configured to obtain first parameter configuration information of the test item based on first operation information. The second configuration module 312 may be configured to obtain second parameter configuration information of the test item based on second operation information. The operation step library module 32 may be configured to obtain operation step information of the test item based on operation information of the operation step library module.

The test requirement structured system 3 may be further configured to send the related configuration information of the parameter to the report system 4.

The report system 4 may be configured to: receive the related configuration information of the parameter sent by the test requirement structured system and the data report sent by the upper-level computer, and check the data report based on the related configuration information of the parameter to determine whether the data report matches the related configuration information of the parameter.

In some embodiments, the upper-level computer 1 may be further configured to control, based on the target test formula, the test device to perform an insulation impedance test on the product to obtain a test result of the insulation impedance test. The test result of the insulation impedance test includes a parameter test result for testing a parameter of the insulation impedance test. The parameter of the insulation impedance test includes at least one of an insulation test voltage, an insulation limiting voltage, an insulation rising time, an insulation falling time, a positive insulation impedance to ground, and a negative insulation impedance to ground.

In some embodiments, the upper-level computer 1 may be further configured to control, based on the target test formula, the test device to perform short circuit detection on the product to obtain a test result of the short circuit detection. The test result of the short circuit detection includes a parameter test result for testing a parameter of the short circuit detection. The parameter of the short circuit detection includes at least one of a positive resistance to ground, a negative resistance to ground, and a positive-negative resistance.

In some embodiments, the upper-level computer 1 may be further configured to control, based on the target test formula, the test device to perform a 12 V negative electrode resistance test on the product to obtain a test result of the 12 V negative electrode resistance test. The test result of the 12 V negative electrode resistance test includes a parameter test result for testing a parameter of the 12 V negative electrode resistance test. The parameter of the 12 V negative electrode resistance test includes a conducting resistance.

In some embodiments, the upper-level computer 1 may be further configured to control, based on the target test formula, the test device to perform a program burning test on the product to obtain a test result of the program burning test. The test result of the program burning test includes a parameter test result for testing a parameter of the program burning test. The parameter of the program burning test includes at least one of boot version information, battery management unit software version information, and battery management unit hardware version information.

In these embodiments of this disclosure, the test system may include an upper-level computer, a test device, and a test requirement structured system. The test device is connected to the upper-level computer, and the test requirement structured system is connected to the upper-level computer. The test requirement structured system is configured to generate an initial test formula based on a test item requirement. The initial test formula includes related information of the test item requirement. The upper-level computer is configured to: obtain the initial test formula from the test requirement structured system in response to test formula download instruction, convert the initial test formula into a target test formula in an extensible markup language format, and control, based on the target test formula, the test device to test a product to obtain a test result. It can be seen that the upper-level computer in the test system is connected to the test device and the test requirement structured system, so that the upper-level computer can obtain the initial test formula from the test requirement structured system when receiving the test formula download instruction. The initial test formula is generated by the test requirement structured system, and the upper-level computer may automatically convert the initial test formula into the target test formula in the extensible markup language format. This improves obtaining efficiency of the test formula. In this way, the upper-level computer can control, based on the target test formula, the test device to test the product. This improves test efficiency.

Persons skilled in the art should understand that the embodiments of this disclosure may be provided as a method, a system, or a computer program product. Therefore, this disclosure may use a form of a hardware embodiment, a software embodiment, or an embodiment with a combination of software and hardware.

The foregoing descriptions are merely example embodiments of this disclosure and are not intended to limit the protection scope of this disclosure.

### Industrial applicability

The embodiments of this disclosure provide an end-of-line test method, applied to a test system. The test system includes an upper-level computer, a test device, and a test requirement structured system. This can effectively improve generation efficiency and accuracy of a test formula, thereby improving test efficiency.

## Claims

1. An end-of-line test method, applied to a test system, wherein the test system comprises an upper-level computer, a test device, and a test requirement structured system, and the method comprises:
obtaining (101), by the upper-level computer, an initial test formula from the test requirement structured system in response to a test formula download instruction, wherein the test requirement structured system is configured to generate the initial test formula based on a test item requirement, and the initial test formula comprises related information of the test item requirement;
converting (102), by the upper-level computer, the initial test formula into a target test formula in an extensible markup language format; and
controlling (103), by the upper-level computer based on the target test formula, the test device to test a product to obtain a test result, **characterized in that** a test item library and an instruction library are deployed on the upper-level computer, and the converting (102), by the upper-level computer, the initial test formula into a target test formula in an extensible markup language format comprises:
performing, by the upper-level computer, matching processing on the initial test formula and the test item library to obtain test item data in an extensible markup language format;
performing matching processing on the initial test formula and the instruction library to obtain an executable instruction in an extensible markup language format; and
generating the target test formula based on the test item data in the extensible markup language format and the executable instruction in the extensible markup language format.

2. The end-of-line test method according to claim 1, wherein the obtaining (101), by the upper-level computer, an initial test formula from the test requirement structured system in response to a test formula download instruction comprises:
obtaining, by the upper-level computer through querying, the initial test formula from test formula data stored in the test requirement structured system based on identification information indicated by the test formula download instruction, and downloading the initial test formula, wherein the identification information comprises project identification information, production line identification information, and device identification information.

3. The end-of-line test method according to any one of claims 1 or 2, wherein the method further comprises:
when receiving formula modify operation information, modifying, by the upper-level computer, the target test formula to obtain a modified test formula, wherein the formula modify operation information comprises test item add operation information, test item delete operation information, and execution sequence modify operation information; and
controlling, by the upper-level computer based on the modified test formula, the test device to test the product.

4. The end-of-line test method according to claim 3, wherein the method further comprises:
sending, by the upper-level computer, the modified test formula to the test requirement structured system, so that the test requirement structured system stores the modified test formula.

5. The end-of-line test method according to any one of claims 1 to 4, wherein the test system further comprises a report system, and after the controlling, by the upper-level computer based on the target test formula, the test device to test a product to obtain a test result, the method further comprises:
generating, by the upper-level computer, a data report based on the test result and parameter code in the initial test formula, and sending the data report to the report system; and
checking, by the report system, the data report.

6. The end-of-line test method according to any one of claims 1 to 5, wherein the test requirement structured system comprises a test item parameter configuration module and an operation step library module, and the method further comprises:
obtaining (201), by the test requirement structured system, related configuration information of a parameter of a test item in response to operation information of the test item parameter configuration module;
obtaining (202), by the test requirement structured system, related configuration information of an operation step of the test item in response to operation information of the operation step library module; and
generating (203), by the test requirement structured system, the initial test formula based on the related configuration information of the parameter and the related configuration information of the operation step.

7. The end-of-line test method according to claim 6, wherein the test item parameter configuration module comprises a first configuration module and a second configuration module, and the obtaining (201), by the test requirement structured system, related configuration information of a parameter of a test item in response to operation information of the test item parameter configuration module comprises:
obtaining, by the test requirement structured system, first parameter configuration information of the test item in response to first operation information corresponding to the first configuration module, wherein the first parameter configuration information comprises at least a first parameter name, first parameter code, and a first parameter specification;
obtaining, by the test requirement structured system, second parameter configuration information of the test item in response to second operation information corresponding to the second configuration module, wherein the second parameter configuration information comprises at least a second parameter name, second parameter code, and a second parameter specification; and
obtaining, by the test requirement structured system, the related configuration information of the parameter based on the first parameter configuration information and the second parameter configuration information.

8. The end-of-line test method according to claim 6, wherein the method further comprises:
sending, by the test requirement structured system, the related configuration information of the parameter to the report system; and
checking, by the report system, the data report based on the related configuration information of the parameter to determine whether the data report matches the related configuration information of the parameter.

9. The end-of-line test method according to claim 6, wherein the controlling (103), by the upper-level computer based on the target test formula, the test device to test a product to obtain a test result comprises:
controlling, by the upper-level computer based on the target test formula, the test device to perform an insulation impedance test on the product to obtain a test result of the insulation impedance test, wherein the test result of the insulation impedance test comprises a parameter test result for testing a parameter of the insulation impedance test, and the parameter of the insulation impedance test comprises at least one of an insulation test voltage, an insulation limiting voltage, an insulation rising time, an insulation falling time, a positive insulation impedance to ground, and a negative insulation impedance to ground.

10. The end-of-line test method according to claim 6, wherein the controlling (103), by the upper-level computer based on the target test formula, the test device to test a product to obtain a test result comprises:
controlling, by the upper-level computer based on the target test formula, the test device to perform short circuit detection on the product to obtain a test result of the short circuit detection, wherein the test result of the short circuit detection comprises a parameter test result for testing a parameter of the short circuit detection, and the parameter of the short circuit detection comprises at least one of a positive resistance to ground, a negative resistance to ground, and a positive-negative resistance.

11. The end-of-line test method according to claim 6, wherein the controlling (103), by the upper-level computer based on the target test formula, the test device to test a product to obtain a test result comprises:
controlling, by the upper-level computer based on the target test formula, the test device to perform a 12 V negative electrode resistance test on the product to obtain a test result of the 12 V negative electrode resistance test, wherein the test result of the 12 V negative electrode resistance test comprises a parameter test result for testing a parameter of the 12 V negative electrode resistance test, and the parameter of the 12 V negative electrode resistance test comprises a conducting resistance.

12. The end-of-line test method according to claim 6, wherein the controlling (103), by the upper-level computer based on the target test formula, the test device to test a product to obtain a test result comprises:
controlling, by the upper-level computer based on the target test formula, the test device to perform a program burning test on the product to obtain a test result of the program burning test, wherein the test result of the program burning test comprises a parameter test result for testing a parameter of the program burning test, and the parameter of the program burning test comprises at least one of boot version information, battery management unit software version information, and battery management unit hardware version information.

13. A test system (0), comprising an upper-level computer (1), a test device (2), and a test requirement structured system (3), wherein
the test device (2) is connected to the upper-level computer (1);
the test requirement structured system (3) is connected to the upper-level computer (1);
the test requirement structured system (3) is configured to generate an initial test formula (114) based on a test item requirement, wherein the initial test formula (114) comprises related information of the test item requirement; and
the upper-level computer (1) is configured to: obtain the initial test formula (114) from the test requirement structured system (3) in response to a test formula download instruction, convert the initial test formula (114) into a target test formula in an extensible markup language format, and control, based on the target test formula, the test device to test a product to obtain a test result, **characterized in that** a test item library and an instruction library are deployed on the upper-level computer, and the upper-level computer is configured to convert the initial test formula (114) into a target test formula in an extensible markup language format by
performing a matching processing on the initial test formula and the test item library to obtain test item data in an extensible markup language format;
performing a matching processing on the initial test formula and the instruction library to obtain an executable instruction in an extensible markup language format; and
generating the target test formula based on the test item data in the extensible markup language format and the executable instruction in the extensible markup language format.

14. The test system (0) according to claim 13, wherein the test system (0) further comprises a report system (4), and the report system (4) is connected to the upper-level computer (1) and the test requirement structured system (3); and
the report system (4) is configured to: receive related configuration information of a parameter (116) sent by the test requirement structured system (3) and a data report (115) sent by the upper-level computer (1), and check the data report (115) based on the related configuration information of the parameter (116) to determine whether the data report (115) matches the related configuration information of the parameter (116).

## Patentansprüche

1. End-of-Line-Testverfahren, angewendet auf ein Testsystem, wobei das Testsystem einen übergeordneten Computer, eine Testvorrichtung und ein strukturiertes Testanforderungssystem umfasst, und das Verfahren umfasst:
Erhalten (101), durch den übergeordneten Computer, einer initialen Testformel von dem strukturierten Testanforderungssystem in Reaktion auf eine Testformel-Download-Anweisung, wobei das strukturierte Testanforderungssystem dazu konfiguriert ist, die initiale Testformel basierend auf einer Testelement-Anforderung zu erzeugen, und die initiale Testformel zugehörige Informationen der Testelement-Anforderung umfasst;
Umwandeln (102), durch den übergeordneten Computer, der initialen Testformel in eine Ziel-Testformel in einem erweiterbaren Auszeichnungssprachenformat; und
Steuern (103), durch den übergeordneten Computer basierend auf der Ziel-Testformel, der Testvorrichtung, um ein Produkt zu testen, um ein Testergebnis zu erhalten, **dadurch gekennzeichnet, dass** eine Testelementbibliothek und eine Anweisungsbibliothek auf dem übergeordneten Computer eingerichtet sind, und das Umwandeln (102), durch den übergeordneten Computer, der initialen Testformel in eine Ziel-Testformel in einem erweiterbaren Auszeichnungssprachenformat umfasst:
Durchführen, durch den übergeordneten Computer, einer Abgleichverarbeitung an der initialen Testformel und der Testelementbibliothek, um Testelementdaten in einem erweiterbaren Auszeichnungssprachenformat zu erhalten;
Durchführen einer Abgleichverarbeitung an der initialen Testformel und der Anweisungsbibliothek, um eine ausführbare Anweisung in einem erweiterbaren Auszeichnungssprachenformat zu erhalten; und
Erzeugen der Ziel-Testformel basierend auf den Testelementdaten in dem erweiterbaren Auszeichnungssprachenformat und der ausführbaren Anweisung in dem erweiterbaren Auszeichnungssprachenformat.

2. End-of-Line-Testverfahren nach Anspruch 1, wobei das Erhalten (101), durch den übergeordneten Computer, einer initialen Testformel von dem strukturierten Testanforderungssystem in Reaktion auf eine Testformel-Download-Anweisung umfasst:
Erhalten, durch den übergeordneten Computer mittels Abfragen, der initialen Testformel aus in dem strukturierten Testanforderungssystem gespeicherten Testformeldaten basierend auf durch die Testformel-Download-Anweisung angegebenen Identifikationsinformationen, und Herunterladen der initialen Testformel, wobei die Identifikationsinformationen Projektidentifikationsinformationen, Produktionslinienidentifikationsinformationen und Vorrichtungsidentifikationsinformationen umfassen.

3. End-of-Line-Testverfahren nach einem der Ansprüche 1 oder 2, wobei das Verfahren ferner umfasst:
bei Empfang von Formelmodifikations-Bedienungsinformationen, Modifizieren, durch den übergeordneten Computer, der Ziel-Testformel, um eine modifizierte Testformel zu erhalten, wobei die Formelmodifikations-Bedienungsinformationen Testelement-Hinzufügungs-Bedienungsinformationen, Testelement-Löschungs-Bedienungsinformationen und Ausführungsreihenfolge-Modifikations-Bedienungsinformationen umfassen; und
Steuern, durch den übergeordneten Computer basierend auf der modifizierten Testformel, der Testvorrichtung, um das Produkt zu testen.

4. End-of-Line-Testverfahren nach Anspruch 3, wobei das Verfahren ferner umfasst:
Senden, durch den übergeordneten Computer, der modifizierten Testformel an das strukturierte Testanforderungssystem, sodass das strukturierte Testanforderungssystem die modifizierte Testformel speichert.

5. End-of-Line-Testverfahren nach einem der Ansprüche 1 bis 4, wobei das Testsystem ferner ein Berichtssystem umfasst, und nach dem Steuern, durch den übergeordneten Computer basierend auf der Ziel-Testformel, der Testvorrichtung, um ein Produkt zu testen, um ein Testergebnis zu erhalten, das Verfahren ferner umfasst:
Erzeugen, durch den übergeordneten Computer, eines Datenberichts basierend auf dem Testergebnis und Parametercode in der initialen Testformel, und Senden des Datenberichts an das Berichtssystem; und
Prüfen, durch das Berichtssystem, des Datenberichts.

6. End-of-Line-Testverfahren nach einem der Ansprüche 1 bis 5, wobei das strukturierte Testanforderungssystem ein Testelementparameter-Konfigurationsmodul und ein Bedienungsschritt-Bibliotheksmodul umfasst, und das Verfahren ferner umfasst:
Erhalten (201), durch das strukturierte Testanforderungssystem, zugehöriger Konfigurationsinformationen eines Parameters eines Testelements in Reaktion auf Bedienungsinformationen des Testelementparameter-Konfigurationsmoduls;
Erhalten (202), durch das strukturierte Testanforderungssystem, zugehöriger Konfigurationsinformationen eines Bedienungsschritts des Testelements in Reaktion auf Bedienungsinformationen des Bedienungsschritt-Bibliotheksmoduls; und
Erzeugen (203), durch das strukturierte Testanforderungssystem, der initialen Testformel basierend auf den zugehörigen Konfigurationsinformationen des Parameters und den zugehörigen Konfigurationsinformationen des Bedienungsschritts.

7. End-of-Line-Testverfahren nach Anspruch 6, wobei das Testelementparameter-Konfigurationsmodul ein erstes Konfigurationsmodul und ein zweites Konfigurationsmodul umfasst, und das Erhalten (201), durch das strukturierte Testanforderungssystem, zugehöriger Konfigurationsinformationen eines Parameters eines Testelements in Reaktion auf Bedienungsinformationen des Testelementparameter-Konfigurationsmoduls umfasst:
Erhalten, durch das strukturierte Testanforderungssystem, erster Parameterkonfigurationsinformationen des Testelements in Reaktion auf erste Bedienungsinformationen, die dem ersten Konfigurationsmodul entsprechen, wobei die ersten Parameterkonfigurationsinformationen mindestens einen ersten Parameternamen, einen ersten Parametercode und eine erste Parameterspezifikation umfassen;
Erhalten, durch das strukturierte Testanforderungssystem, zweiter Parameterkonfigurationsinformationen des Testelements in Reaktion auf zweite Bedienungsinformationen, die dem zweiten Konfigurationsmodul entsprechen, wobei die zweiten Parameterkonfigurationsinformationen mindestens einen zweiten Parameternamen, einen zweiten Parametercode und eine zweite Parameterspezifikation umfassen; und
Erhalten, durch das strukturierte Testanforderungssystem, der zugehörigen Konfigurationsinformationen des Parameters basierend auf den ersten Parameterkonfigurationsinformationen und den zweiten Parameterkonfigurationsinformationen.

8. End-of-Line-Testverfahren nach Anspruch 6, wobei das Verfahren ferner umfasst:
Senden, durch das strukturierte Testanforderungssystem, der zugehörigen Konfigurationsinformationen des Parameters an das Berichtssystem; und
Prüfen, durch das Berichtssystem, des Datenberichts basierend auf den zugehörigen Konfigurationsinformationen des Parameters, um zu bestimmen, ob der Datenbericht mit den zugehörigen Konfigurationsinformationen des Parameters übereinstimmt.

9. End-of-Line-Testverfahren nach Anspruch 6, wobei das Steuern (103), durch den übergeordneten Computer basierend auf der Ziel-Testformel, der Testvorrichtung, um ein Produkt zu testen, um ein Testergebnis zu erhalten, umfasst:
Steuern, durch den übergeordneten Computer basierend auf der Ziel-Testformel, der Testvorrichtung, um einen Isolationsimpedanztest an dem Produkt durchzuführen, um ein Testergebnis des Isolationsimpedanztests zu erhalten, wobei das Testergebnis des Isolationsimpedanztests ein Parametertestergebnis zum Testen eines Parameters des Isolationsimpedanztests umfasst, und der Parameter des Isolationsimpedanztests mindestens eines von einer Isolationstestspannung, einer Isolationsbegrenzungsspannung, einer Isolationsanstiegszeit, einer Isolationsabfallzeit, einer positiven Isolationsimpedanz gegen Erde und einer negativen Isolationsimpedanz gegen Erde umfasst.

10. End-of-Line-Testverfahren nach Anspruch 6, wobei das Steuern (103), durch den übergeordneten Computer basierend auf der Ziel-Testformel, der Testvorrichtung, um ein Produkt zu testen, um ein Testergebnis zu erhalten, umfasst:
Steuern, durch den übergeordneten Computer basierend auf der Ziel-Testformel, der Testvorrichtung, um eine Kurzschlusserkennung an dem Produkt durchzuführen, um ein Testergebnis der Kurzschlusserkennung zu erhalten, wobei das Testergebnis der Kurzschlusserkennung ein Parametertestergebnis zum Testen eines Parameters der Kurzschlusserkennung umfasst, und der Parameter der Kurzschlusserkennung mindestens eines von einem positiven Widerstand gegen Erde, einem negativen Widerstand gegen Erde und einem Positiv-Negativ-Widerstand umfasst.

11. End-of-Line-Testverfahren nach Anspruch 6, wobei das Steuern (103), durch den übergeordneten Computer basierend auf der Ziel-Testformel, der Testvorrichtung, um ein Produkt zu testen, um ein Testergebnis zu erhalten, umfasst:
Steuern, durch den übergeordneten Computer basierend auf der Ziel-Testformel, der Testvorrichtung, um einen 12-V-Negativelektroden-Widerstandstest an dem Produkt durchzuführen, um ein Testergebnis des 12-V-Negativelektroden-Widerstandstests zu erhalten, wobei das Testergebnis des 12-V-Negativelektroden-Widerstandstests ein Parametertestergebnis zum Testen eines Parameters des 12-V-Negativelektroden-Widerstandstests umfasst, und der Parameter des 12-V-Negativelektroden-Widerstandstests einen Durchgangswiderstand umfasst.

12. End-of-Line-Testverfahren nach Anspruch 6, wobei das Steuern (103), durch den übergeordneten Computer basierend auf der Ziel-Testformel, der Testvorrichtung, um ein Produkt zu testen, um ein Testergebnis zu erhalten, umfasst:
Steuern, durch den übergeordneten Computer basierend auf der Ziel-Testformel, der Testvorrichtung, um einen Programmbrenntest an dem Produkt durchzuführen, um ein Testergebnis des Programmbrenntests zu erhalten, wobei das Testergebnis des Programmbrenntests ein Parametertestergebnis zum Testen eines Parameters des Programmbrenntests umfasst, und der Parameter des Programmbrenntests mindestens eines von Boot-Versionsinformationen, Batteriemanagementeinheit-Softwareversionsinformationen und Batteriemanagementeinheit-Hardwareversionsinformationen umfasst.

13. Testsystem (0), umfassend einen übergeordneten Computer (1), eine Testvorrichtung (2) und ein strukturiertes Testanforderungssystem (3), wobei
die Testvorrichtung (2) mit dem übergeordneten Computer (1) verbunden ist;
das strukturierte Testanforderungssystem (3) mit dem übergeordneten Computer (1) verbunden ist;
das strukturierte Testanforderungssystem (3) dazu konfiguriert ist, eine initiale Testformel (114) basierend auf einer Testelement-Anforderung zu erzeugen, wobei die initiale Testformel (114) zugehörige Informationen der Testelement-Anforderung umfasst; und
der übergeordnete Computer (1) dazu konfiguriert ist: die initiale Testformel (114) von dem strukturierten Testanforderungssystem (3) in Reaktion auf eine Testformel-Download-Anweisung zu erhalten, die initiale Testformel (114) in eine Ziel-Testformel in einem erweiterbaren Auszeichnungssprachenformat umzuwandeln, und, basierend auf der Ziel-Testformel, die Testvorrichtung zu steuern, um ein Produkt zu testen, um ein Testergebnis zu erhalten, **dadurch gekennzeichnet, dass** eine Testelementbibliothek und eine Anweisungsbibliothek auf dem übergeordneten Computer eingerichtet sind, und der übergeordnete Computer dazu konfiguriert ist, die initiale Testformel (114) in eine Ziel-Testformel in einem erweiterbaren Auszeichnungssprachenformat umzuwandeln durch
Durchführen einer Abgleichverarbeitung an der initialen Testformel und der Testelementbibliothek, um Testelementdaten in einem erweiterbaren Auszeichnungssprachenformat zu erhalten;
Durchführen einer Abgleichverarbeitung an der initialen Testformel und der Anweisungsbibliothek, um eine ausführbare Anweisung in einem erweiterbaren Auszeichnungssprachenformat zu erhalten; und
Erzeugen der Ziel-Testformel basierend auf den Testelementdaten in dem erweiterbaren Auszeichnungssprachenformat und der ausführbaren Anweisung in dem erweiterbaren Auszeichnungssprachenformat.

14. Testsystem (0) nach Anspruch 13, wobei das Testsystem (0) ferner ein Berichtssystem (4) umfasst, und das Berichtssystem (4) mit dem übergeordneten Computer (1) und dem strukturierten Testanforderungssystem (3) verbunden ist; und
das Berichtssystem (4) dazu konfiguriert ist: zugehörige Konfigurationsinformationen eines Parameters (116), die durch das strukturierte Testanforderungssystem (3) gesendet werden, und einen Datenbericht (115), der durch den übergeordneten Computer (1) gesendet wird, zu empfangen, und den Datenbericht (115) basierend auf den zugehörigen Konfigurationsinformationen des Parameters (116) zu prüfen, um zu bestimmen, ob der Datenbericht (115) mit den zugehörigen Konfigurationsinformationen des Parameters (116) übereinstimmt.

## Revendications

1. Procédé d'essai de fin de ligne, appliqué à un système d'essai, dans lequel le système d'essai comprend un ordinateur de niveau supérieur, un dispositif d'essai et un système structuré d'exigences d'essai, et le procédé comprend :
l'obtention (101), par l'ordinateur de niveau supérieur, d'une formule d'essai initiale à partir du système structuré d'exigences d'essai en réponse à une instruction de téléchargement de formule d'essai, dans lequel le système structuré d'exigences d'essai est configuré pour générer la formule d'essai initiale sur la base d'une exigence d'élément d'essai, et la formule d'essai initiale comprend des informations connexes de l'exigence d'élément d'essai ;
la conversion (102), par l'ordinateur de niveau supérieur, de la formule d'essai initiale en une formule d'essai cible dans un format de langage de balisage extensible ; et
la commande (103), par l'ordinateur de niveau supérieur sur la base de la formule d'essai cible, du dispositif d'essai pour tester un produit afin d'obtenir un résultat d'essai, **caractérisé en ce qu'**une bibliothèque d'éléments d'essai et une bibliothèque d'instructions sont déployées sur l'ordinateur de niveau supérieur, et la conversion (102), par l'ordinateur de niveau supérieur, de la formule d'essai initiale en une formule d'essai cible dans un format de langage de balisage extensible comprend :
la réalisation, par l'ordinateur de niveau supérieur, d'un traitement de mise en correspondance sur la formule d'essai initiale et la bibliothèque d'éléments d'essai afin d'obtenir des données d'élément d'essai dans un format de langage de balisage extensible ;
la réalisation d'un traitement de mise en correspondance sur la formule d'essai initiale et la bibliothèque d'instructions afin d'obtenir une instruction exécutable dans un format de langage de balisage extensible ; et
la génération de la formule d'essai cible sur la base des données d'élément d'essai dans le format de langage de balisage extensible et de l'instruction exécutable dans le format de langage de balisage extensible.

2. Procédé d'essai de fin de ligne selon la revendication 1, dans lequel l'obtention (101), par l'ordinateur de niveau supérieur, d'une formule d'essai initiale à partir du système structuré d'exigences d'essai en réponse à une instruction de téléchargement de formule d'essai comprend :
l'obtention, par l'ordinateur de niveau supérieur au moyen d'une interrogation, de la formule d'essai initiale à partir de données de formule d'essai stockées dans le système structuré d'exigences d'essai sur la base d'informations d'identification indiquées par l'instruction de téléchargement de formule d'essai, et le téléchargement de la formule d'essai initiale, dans lequel les informations d'identification comprennent des informations d'identification de projet, des informations d'identification de ligne de production et des informations d'identification de dispositif.

3. Procédé d'essai de fin de ligne selon l'une quelconque des revendications 1 ou 2, dans lequel le procédé comprend en outre :
lors de la réception d'informations d'opération de modification de formule, la modification, par l'ordinateur de niveau supérieur, de la formule d'essai cible afin d'obtenir une formule d'essai modifiée, dans lequel les informations d'opération de modification de formule comprennent des informations d'opération d'ajout d'élément d'essai, des informations d'opération de suppression d'élément d'essai et des informations d'opération de modification de séquence d'exécution ; et
la commande, par l'ordinateur de niveau supérieur sur la base de la formule d'essai modifiée, du dispositif d'essai pour tester le produit.

4. Procédé d'essai de fin de ligne selon la revendication 3, dans lequel le procédé comprend en outre :
l'envoi, par l'ordinateur de niveau supérieur, de la formule d'essai modifiée au système structuré d'exigences d'essai, de sorte que le système structuré d'exigences d'essai stocke la formule d'essai modifiée.

5. Procédé d'essai de fin de ligne selon l'une quelconque des revendications 1 à 4, dans lequel le système d'essai comprend en outre un système de rapport, et après la commande, par l'ordinateur de niveau supérieur sur la base de la formule d'essai cible, du dispositif d'essai pour tester un produit afin d'obtenir un résultat d'essai, le procédé comprend en outre :
la génération, par l'ordinateur de niveau supérieur, d'un rapport de données sur la base du résultat d'essai et d'un code de paramètre dans la formule d'essai initiale, et l'envoi du rapport de données au système de rapport ; et
la vérification, par le système de rapport, du rapport de données.

6. Procédé d'essai de fin de ligne selon l'une quelconque des revendications 1 à 5, dans lequel le système structuré d'exigences d'essai comprend un module de configuration de paramètre d'élément d'essai et un module de bibliothèque d'étapes d'opération, et le procédé comprend en outre :
l'obtention (201), par le système structuré d'exigences d'essai, d'informations de configuration connexes d'un paramètre d'un élément d'essai en réponse à des informations d'opération du module de configuration de paramètre d'élément d'essai ;
l'obtention (202), par le système structuré d'exigences d'essai, d'informations de configuration connexes d'une étape d'opération de l'élément d'essai en réponse à des informations d'opération du module de bibliothèque d'étapes d'opération ; et
la génération (203), par le système structuré d'exigences d'essai, de la formule d'essai initiale sur la base des informations de configuration connexes du paramètre et des informations de configuration connexes de l'étape d'opération.

7. Procédé d'essai de fin de ligne selon la revendication 6, dans lequel le module de configuration de paramètre d'élément d'essai comprend un premier module de configuration et un deuxième module de configuration, et l'obtention (201), par le système structuré d'exigences d'essai, d'informations de configuration connexes d'un paramètre d'un élément d'essai en réponse à des informations d'opération du module de configuration de paramètre d'élément d'essai comprend :
l'obtention, par le système structuré d'exigences d'essai, de premières informations de configuration de paramètre de l'élément d'essai en réponse à des premières informations d'opération correspondant au premier module de configuration, dans lequel les premières informations de configuration de paramètre comprennent au moins un premier nom de paramètre, un premier code de paramètre et une première spécification de paramètre ;
l'obtention, par le système structuré d'exigences d'essai, de deuxièmes informations de configuration de paramètre de l'élément d'essai en réponse à des deuxièmes informations d'opération correspondant au deuxième module de configuration, dans lequel les deuxièmes informations de configuration de paramètre comprennent au moins un deuxième nom de paramètre, un deuxième code de paramètre et une deuxième spécification de paramètre ; et
l'obtention, par le système structuré d'exigences d'essai, des informations de configuration connexes du paramètre sur la base des premières informations de configuration de paramètre et des deuxièmes informations de configuration de paramètre.

8. Procédé d'essai de fin de ligne selon la revendication 6, dans lequel le procédé comprend en outre :
l'envoi, par le système structuré d'exigences d'essai, des informations de configuration connexes du paramètre au système de rapport ; et
la vérification, par le système de rapport, du rapport de données sur la base des informations de configuration connexes du paramètre afin de déterminer si le rapport de données correspond aux informations de configuration connexes du paramètre.

9. Procédé d'essai de fin de ligne selon la revendication 6, dans lequel la commande (103), par l'ordinateur de niveau supérieur sur la base de la formule d'essai cible, du dispositif d'essai pour tester un produit afin d'obtenir un résultat d'essai comprend :
la commande, par l'ordinateur de niveau supérieur sur la base de la formule d'essai cible, du dispositif d'essai pour effectuer un essai d'impédance d'isolement sur le produit afin d'obtenir un résultat d'essai de l'essai d'impédance d'isolement, dans lequel le résultat d'essai de l'essai d'impédance d'isolement comprend un résultat d'essai de paramètre pour tester un paramètre de l'essai d'impédance d'isolement, et le paramètre de l'essai d'impédance d'isolement comprend au moins l'un d'une tension d'essai d'isolement, d'une tension limite d'isolement, d'un temps de montée d'isolement, d'un temps de descente d'isolement, d'une impédance d'isolement positive à la terre et d'une impédance d'isolement négative à la terre.

10. Procédé d'essai de fin de ligne selon la revendication 6, dans lequel la commande (103), par l'ordinateur de niveau supérieur sur la base de la formule d'essai cible, du dispositif d'essai pour tester un produit afin d'obtenir un résultat d'essai comprend :
la commande, par l'ordinateur de niveau supérieur sur la base de la formule d'essai cible, du dispositif d'essai pour effectuer une détection de court-circuit sur le produit afin d'obtenir un résultat d'essai de la détection de court-circuit, dans lequel le résultat d'essai de la détection de court-circuit comprend un résultat d'essai de paramètre pour tester un paramètre de la détection de court-circuit, et le paramètre de la détection de court-circuit comprend au moins l'un d'une résistance positive à la terre, d'une résistance négative à la terre et d'une résistance positive-négative.

11. Procédé d'essai de fin de ligne selon la revendication 6, dans lequel la commande (103), par l'ordinateur de niveau supérieur sur la base de la formule d'essai cible, du dispositif d'essai pour tester un produit afin d'obtenir un résultat d'essai comprend :
la commande, par l'ordinateur de niveau supérieur sur la base de la formule d'essai cible, du dispositif d'essai pour effectuer un essai de résistance d'électrode négative de 12 V sur le produit afin d'obtenir un résultat d'essai de l'essai de résistance d'électrode négative de 12 V, dans lequel le résultat d'essai de l'essai de résistance d'électrode négative de 12 V comprend un résultat d'essai de paramètre pour tester un paramètre de l'essai de résistance d'électrode négative de 12 V, et le paramètre de l'essai de résistance d'électrode négative de 12 V comprend une résistance de conduction.

12. Procédé d'essai de fin de ligne selon la revendication 6, dans lequel la commande (103), par l'ordinateur de niveau supérieur sur la base de la formule d'essai cible, du dispositif d'essai pour tester un produit afin d'obtenir un résultat d'essai comprend :
la commande, par l'ordinateur de niveau supérieur sur la base de la formule d'essai cible, du dispositif d'essai pour effectuer un essai de gravure de programme sur le produit afin d'obtenir un résultat d'essai de l'essai de gravure de programme, dans lequel le résultat d'essai de l'essai de gravure de programme comprend un résultat d'essai de paramètre pour tester un paramètre de l'essai de gravure de programme, et le paramètre de l'essai de gravure de programme comprend au moins l'une d'informations de version d'amorçage, d'informations de version de logiciel d'unité de gestion de batterie et d'informations de version de matériel d'unité de gestion de batterie.

13. Système d'essai (0), comprenant un ordinateur de niveau supérieur (1), un dispositif d'essai (2) et un système structuré d'exigences d'essai (3), dans lequel
le dispositif d'essai (2) est connecté à l'ordinateur de niveau supérieur (1) ;
le système structuré d'exigences d'essai (3) est connecté à l'ordinateur de niveau supérieur (1) ;
le système structuré d'exigences d'essai (3) est configuré pour générer une formule d'essai initiale (114) sur la base d'une exigence d'élément d'essai, dans lequel la formule d'essai initiale (114) comprend des informations connexes de l'exigence d'élément d'essai ; et
l'ordinateur de niveau supérieur (1) est configuré pour : obtenir la formule d'essai initiale (114) à partir du système structuré d'exigences d'essai (3) en réponse à une instruction de téléchargement de formule d'essai, convertir la formule d'essai initiale (114) en une formule d'essai cible dans un format de langage de balisage extensible, et commander, sur la base de la formule d'essai cible, le dispositif d'essai pour tester un produit afin d'obtenir un résultat d'essai, **caractérisé en ce qu'**une bibliothèque d'éléments d'essai et une bibliothèque d'instructions sont déployées sur l'ordinateur de niveau supérieur, et l'ordinateur de niveau supérieur est configuré pour convertir la formule d'essai initiale (114) en une formule d'essai cible dans un format de langage de balisage extensible par
la réalisation d'un traitement de mise en correspondance sur la formule d'essai initiale et la bibliothèque d'éléments d'essai afin d'obtenir des données d'élément d'essai dans un format de langage de balisage extensible ;
la réalisation d'un traitement de mise en correspondance sur la formule d'essai initiale et la bibliothèque d'instructions afin d'obtenir une instruction exécutable dans un format de langage de balisage extensible ; et
la génération de la formule d'essai cible sur la base des données d'élément d'essai dans le format de langage de balisage extensible et de l'instruction exécutable dans le format de langage de balisage extensible.

14. Système d'essai (0) selon la revendication 13, dans lequel le système d'essai (0) comprend en outre un système de rapport (4), et le système de rapport (4) est connecté à l'ordinateur de niveau supérieur (1) et au système structuré d'exigences d'essai (3) ; et
le système de rapport (4) est configuré pour : recevoir des informations de configuration connexes d'un paramètre (116) envoyées par le système structuré d'exigences d'essai (3) et un rapport de données (115) envoyé par l'ordinateur de niveau supérieur (1), et vérifier le rapport de données (115) sur la base des informations de configuration connexes du paramètre (116) afin de déterminer si le rapport de données (115) correspond aux informations de configuration connexes du paramètre (116).
